# EUROPEAN PATENT APPLICATION

(11) **EP 4 737 075 A1**
(43) Date of publication of application: **06.05.2026**
(21) Application number: 25211401.2
(22) Date of filing: 27.10.2025
(51) Int. Cl.: B25J 19/02, B25J 19/06, F16P 3/14

(54) **OBJECT DETECTION SYSTEM**

(30) Priority: 29.10.2024 JP 2024189585; 26.08.2025 JP 2025140818
(71) Applicant: Nachi-Fujikoshi Corp., Tokyo 105-0021 (JP)
(72) Inventor: ONO, Jotaro, Toyama, 930-8511 (JP)
(74) Representative: Plougmann Vingtoft a/s

(57) **Abstract**

An object detection system (1) includes a robot (10), laser sensors (30), and a control apparatus (20). The robot (10) includes a capacitive proximity sensor (110) disposed on an articulated arm (11) of the robot (10). The capacitive proximity sensor (110) detects an interfering object (2). The laser sensors (30) irradiate laser to detect the interfering object (2). The control apparatus (20) is programmed to stop or decelerate operation of the robot (10) based on a detection of the interfering object (2) by at least one of the capacitive proximity sensor (110) and the laser sensors (30).

## Description

### Technical Filed

The present invention relates to an object detection system including a robot and a control apparatus.

### Background Art

Robots equipped with non-contact proximity sensors for detecting interfering objects and robot systems including such robots have been known.

Japanese Patent Application Laid-Open No. 2018-155712 discloses an autonomous apparatus (robot) equipped with a sensor device that includes a first sensor, and second and third sensors located closer to a moving section of the apparatus than the first sensor. The disclosure also teaches that the first sensor comprises a laser sensor, and the second and third sensors comprise proximity sensors.

### Summary

### Technical Problem

The detection ranges of the proximity sensors have a blind area formed by limitation to the laser irradiation angles of the proximity sensors, and the proximity sensors may fail to detect an approaching interfering object if the approaching interfering object is outside the coverages of the detection ranges. Moreover, the sensing directions of some proximity sensors are sometimes fixed. The inventor of the present invention has thus recognized that these proximity sensors have the limited detection coverage that falls short of detecting an interfering object approaching toward the robot from every conceivable direction.

### Solution to Problem

The embodiments of the present application provide an object detection system that can detect an interfering object approaching a robot with high accuracy and within a wide range of detection coverage.

To solve the foregoing issues, an object detection system according to the present invention comprises a robot including a base, an articulated arm connected to the base, and a capacitive proximity sensor disposed on the articulated arm. The capacitive proximity sensor is configured to detect an interfering object. The object detection system according to the present invention further comprises a pair of laser sensors located at positions opposite to each other with respect to the base. The pair of laser sensors are each configured to irradiate laser approximately in parallel to the installation surface of the robot and detect an interfering object. The object detection system according to the present invention further comprises a control apparatus programmed to stop or decelerate the operation of the robot based on a detection of the interfering object by at least one of the capacitive proximity sensor and the laser sensors.

The control apparatus is further programmed to operate the laser sensors to stop or disable the detection by the laser sensors when a part of the articulated arm is positioned in one of the detection ranges that are set for the laser sensors to detect an interfering object.

The control apparatus is further programmed to operate the laser sensors to allow the detection of an interfering object when no part of the articulated arm is positioned within any of the detection ranges of the laser sensors.

The control apparatus is further programmed to calculate a distance between the detected interfering object and the robot from the detection results from the capacitive proximity sensor and the laser sensors, and to stop or decelerate the operation of the robot if the calculated distance is less than a specific distance.

### Advantageous Effect of Invention

The object detection system according to the present invention can detect an interfering object approaching the robot with high accuracy and within a wide range of detection coverage.

### Brief Description of the Drawings

Fig. 1 is a diagram showing an overall configuration of an object detection system according to an embodiment of the present invention;
Fig. 2 is a top view of a robot and laser sensors shown in Fig. 1;
Fig. 3 is a diagram showing a functional configuration of a control apparatus shown in Fig. 1;
Fig. 4 is a flowchart showing an exemplary processes performed by the object detection system shown in Fig. 1;
Fig. 5A is a diagram showing one instance where the object detection system shown in Fig. 1 detects an interfering object; and
Fig. 5B is a diagram showing another instance where the object detection system shown in Fig. 1 detects an interfering object.

### Detailed Description of Embodiments

An embodiment of the present invention (hereinafter, referred to as a "present embodiment") will be described with reference to the accompanying drawings. To facilitate understanding of the present embodiment, similar or the like components and steps in the drawings are denoted by the same reference signs where appropriate, and redundant descriptions will be omitted.

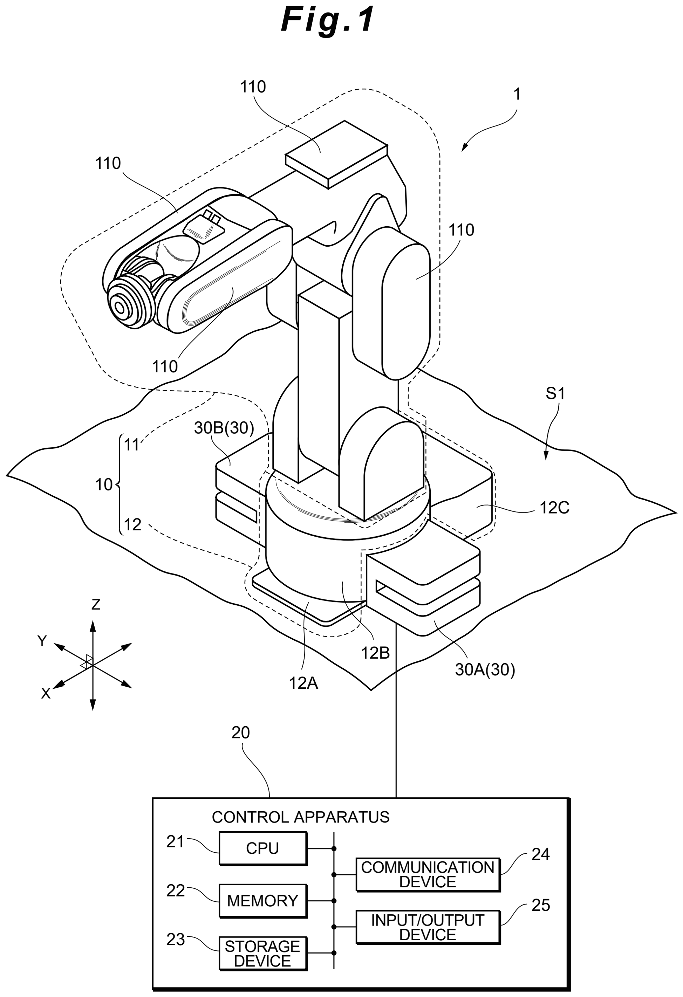

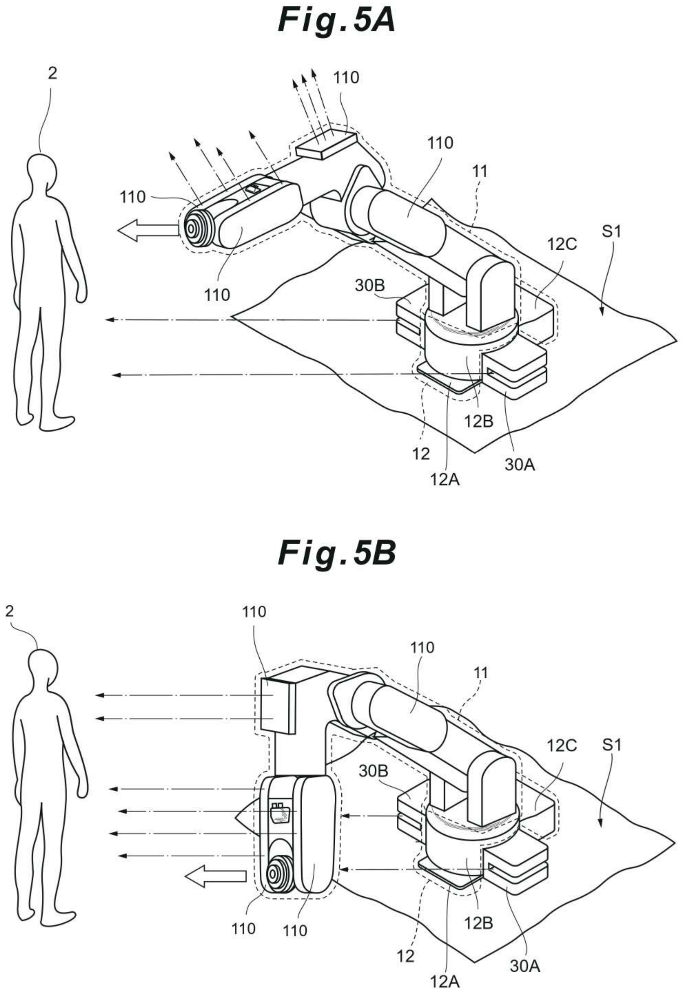

Fig. 1 is a diagram showing an overall configuration of an object detection system 1 according to the present embodiment. Fig. 1 shows the object detection system 1 that includes in its main part a robot 10, a control apparatus 20, and laser sensors 30A and 30B. In the present embodiment, the up-and-down direction in Fig. 1 is defined by the Z-axis direction. In the present embodiment, a direction that is perpendicular to the Z-axis direction, in which laser sensors 30A and 30B, described below, are positioned opposite to each other in Fig. 1, is defined by the Y-axis direction. In the present embodiment, the direction that is orthogonal to the Z- and Y-axis directions in Fig. 1 is defined by the X-axis direction. In the present embodiment, interfering objects 2, such as humans and objects (see Fig. 5A), are assumed to be stationarily present or moving in a spatial area surrounding the robot 10.

The robot 10 is an industrial apparatus including movable parts that are movable in a spatial area extensive in a predetermined distance from the robot 10. Examples of the industrial apparatus include robots, machine tools, and testers with the articulated arm 11. As shown in Fig. 1, the robot 10 includes in its main part the articulated arm 11 and a base 12. The robot 10 is placed on an installation surface S1 located right below the robot 10. That is, the installation surface S1 is a surface on which the robot 10 is installed. Note that the installation surface S1 is usually set orthogonal to the Z-axis direction, and the installation surface S1 is set in parallel to an imaginary X-Y plane defined by the X-axis direction and the Y-axis direction. In the present embodiment, the installation surface S1 is, for example, formed by a floor surface in a room in which the robot 10 is installed.

The articulated arm 11 includes a plurality of robot arms and a plurality of driving joints, for example, and performs various types of works on workpieces, not shown, using a tool connected to its distal end. The various types of works include, for example, irradiating an X-ray, gripping, transporting, rotating, attaching to another workpiece, injecting or applying substances, polishing, screwing, and heating. The articulated arm 11 is connected at its proximal end to the base 12. The articulated arm 11 includes a plurality of capacitive proximity sensors 110 disposed on surfaces of at least some robot arms. The driving joints function as joints that rotatably connect robot arms in series. The driving joints are each provided with a motor for rotational movement and an angle sensor configured to measure rotation angles. Instructed by control commands transmitted from the control apparatus 20 via the base 12, the driving joints execute the rotational movements of the motors at the instructed speeds and angles, or the driving joins stop the operation of the robot, if so instructed. Each driving joint, using an angle sensor, measures a rotation angle between the two adjacent robot arms connected in series at their ends. The articulated arm 11 transmits measurements of rotation angles of the driving joints to the control apparatus 20 via the base 12.

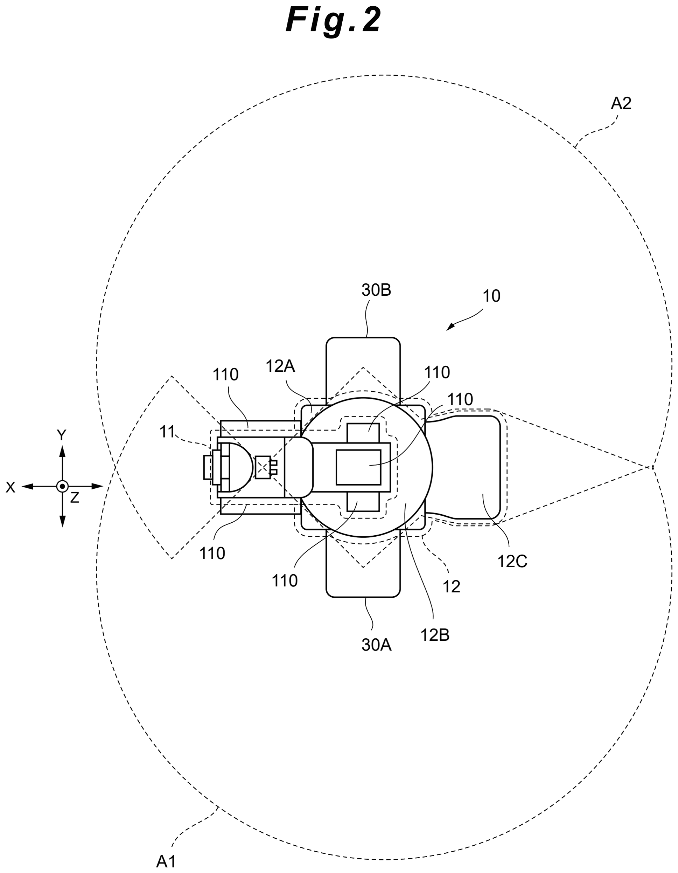

The base 12 constitutes a foundation for supporting the articulated arm 11. The base 12 is installed on the installation surface S1 from which the robot 10 stands. Specifically, the bottom surface of the base 12 is placed in contact with the installation surface S1. The articulated arm 11 extends from the top surface of the base 12, located opposite to the bottom surface thereof. In the Y-axis direction in Fig. 2, the laser sensor 30A is provided to one lateral end of the base 12, and the laser sensor 30B is provided to the other lateral end of the base 12. The base 12 is operably connected to the control apparatus 20 in a manner that allows data transmission between the base 12 and the control apparatus 20.

Note that in this embodiment, the base 12 includes a planar member 12A, a cylindrical member 12B, and a rear-positioned member 12C. The planar member 12A is formed with a rectangular plate and is set to constitute the bottom of the base 12. Specifically, the bottom surface of the planar member 12A is placed in contact with the installation surface S1. The cylindrical member 12B is provided on the planar member 12A. The articulated arm 11 is connected to the top surface of the cylindrical member 12B. The laser sensors 30A and 30B are provided to the cylindrical member 12B so that they are located, respectively, at the sides opposite to each other in the Y-axis direction. The rear-positioned member 12C is attached to the rear side of the cylindrical member 12B. The bottom surface of the rear-positioned member 12C is also placed in contact with the installation surface S1.

The capacitive proximity sensors 110 comprise non-contact proximity sensors. A plurality of the capacitive proximity sensors 110 are disposed on the surfaces of at least some robot arms of the articulated arm 11. Each capacitive proximity sensor 110 detects the presence or absence of an interfering object 2 within its detection range by measuring a potential across the detection electrodes and calculating a capacitance between its detection electrodes and the ground potential. The capacitive proximity sensors 110 transmit detection results to the control apparatus 20, wherein the detection results include the measured capacitances and/or their changed values. In Figs. 1 to 5B, the capacitive proximity sensors 110 are schematically shown for the sake of simple drawings and simple description. In commercial embodiments, the capacitive proximity sensors 110 are housed in exterior casings and are not visible.

The control apparatus 20 includes in its main part a storage device 23 that stores various kinds of programs and various types of information needed for a central processing unit (CPU) 21 to perform processes as well as information about processing results. The control apparatus 20 also includes, in its main part, the CPU 21 that performs various kinds of tasks by executing programs prestored in a memory 22, the storage device 23, or the like. The control apparatus 20 further includes, in its main part, the memory 22 that temporarily deploys therein prestored programs and data needed for the CPU 21 to execute the prestored programs, and a communication device 24 for communicating with external devices. The control apparatus 20 further includes, in its main part, an input/output device 25 that receives control inputs inputted by an operator to operate the control apparatus 20 and displays information provided by the control apparatus 20 to the operator. The control apparatus 20 may be formed with a single information processing apparatus or a plurality of information processing apparatuses.

The control apparatus 20 is programed such that it can communicate with the robot 10. The control apparatus 20, in response to information transmitted from the robot 10, transmits, to the articulated arm 11 via the base 12, control commands for controlling the operation of the robot 10. Alternatively, the control apparatus 20 may directly transmit the control commands to the capacitive proximity sensors 110 and the articulated arm 11 of the robot 10 without transmitting through the base 12. The control apparatus 20 receives detection results of any interfering objects 2 from the capacitive proximity sensors 110 through the base 12 and determines, from the detection results, the presence or absence of any interfering object 2 within the detection ranges. The control apparatus 20 controls the operation of the articulated arm 11 based on a determination result and notifies administrators, users, and others privy to the object detection system 1 of the determination result using a screen display, an audio output, etc.

The laser sensors 30 are reflective-type optical distance sensors that detect the presence or absence of any interfering object 2 within the detection ranges, and if there is detected an interfering object 2, the laser sensor 30 measures the distance between the detected interfering object 2 and the laser sensor 30 that detected the interfering object 2. Specifically, the laser sensor 30 detects the presence or absence of an interfering object 2 and also measures the distance to the detected interfering objects 2 in such a manner that it irradiates laser from its laser irradiation part in a direction approximately parallel to the installation surface S1 of the robot 10 and receives reflected light from the interfering object 2 at its light receiving part. The laser sensors 30 are connected respectively to either side surface of the base 12. Specifically, the laser sensors 30 are disposed as a pair, respectively, at the opposite side surfaces of the installation surface S1 of the robot 10.

The laser sensors 30A and 30B will be described with reference to Fig. 2. Fig. 2 is a top view of the robot 10 that shows the laser sensors 30A and 30B shown in Fig. 1. As shown in Fig. 2, the laser sensor 30A is provided to the base 12, which is placed on the installation surface S1. The laser sensor 30A detects the presence or absence of an interfering object 2 and measures the distance between the laser sensor 30 A and the detected interfering object 2, which is present in a detection range A1 of the robot 10. The laser sensor 30B is provided to the base 12, which is installed on the installation surface S1. The laser sensor 30B detects the presence or absence of an interfering object 2 and measures the distance between the laser sensor 30B and the detected interfering object 2, which is present in a detection range A2 of the robot 10. The detection ranges A1 and A2 extend vertically in the Z-axis direction for the height determined by a preset irradiation angle with reference to the irradiation parts of the laser sensors 30A and 30B.

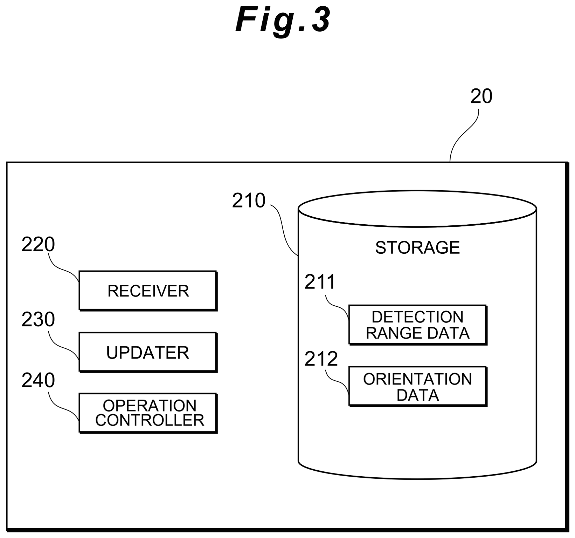

The overall configuration of the object detection system 1 has been described above with reference to Fig. 2. The functional configuration of the control apparatus 20 will be described with reference to Fig. 3. Fig. 3 is a diagram showing the functional configuration of the control apparatus 20 shown in Fig. 1. As shown in Fig. 3, the control apparatus 20 includes in its main part, a storage 210, a receiver 220, an updater 230, and an operation controller 240, for example. The functions of the control apparatus 20, other than the storage 210, are implemented by the CPU 21 executing programs stored in the storage device 23 or the like.

The storage 210 stores detection range data 211 and orientation data 212.

The detection range data 211 includes the detection ranges A1 and A2, in which the laser sensors 30A and 30B can detect an interfering object 2. The detection range data 211 is formed with three-dimensional model data, for example. Examples thereof include data expressed by wireframe models, surface models, solid models, or the like. The detection range data 211 may be set to contain the coordinates of the vertices of three-dimensional models that represent the detection ranges A1 and A2 of the laser sensors 30A and 30B in a virtual three-dimensional space.

The orientation data 212 is three-dimensional data about the robot 10, and represents the shape, position, and direction of the robot 10. The orientation data 212 is expressed by a wireframe mode, surface model, solid model, or the like.

The receiver 220 acquires, from the articulated arm 11 of the robot 10, the measurement results indicative of the rotation angles of the respective driving joints. The receiver 220 acquires measurements from the laser sensors 30A and 30B. The receiver 220 also acquires the detection values from the plurality of capacitive proximity sensors 110 of the robot 10.

The updater 230 changes the position and shape in the orientation data 212 stored in the storage 210, based on the measurements, acquired by the receiver 220, of the rotation angles of the respective driving joints of the articulated arm 11. The updater 230 updates the orientation data 212 in the storage 210 to change the position and shape, using the orientation data 212.

The operation controller 240 controls the operation of the robot 10 and the laser sensors 30A and 30B. Specifically, if a part of the articulated arm 11 found present in one of the detection ranges A1 and A2, within which the laser sensors 30A and 30B can detect an interfering object 2, the operation controller 240 stops or disables the detection by the laser sensors 30A and 30B. The operation controller 240 also stops or decelerates the operation of the robot 10 if a detection result, which comes from either of the capacitive proximity sensors 110 or the laser sensors 30A and 30B, and is acquired by the receiver 220, indicates the presence of an interfering object 2.

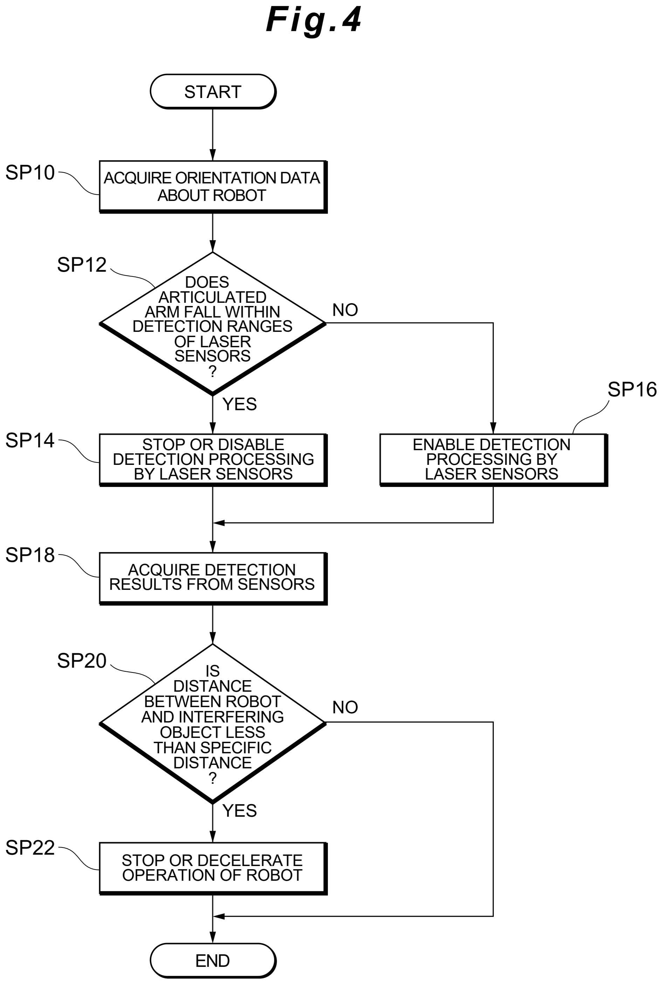

The operation controller 240 stops or decelerates the operation of the robot 10, in response to the detection of an interfering object 2 by either the capacitive proximity sensor 110 or the laser sensors 30A and 30B. The operation controller 240 calculates the distance between the detected interfering object 2 and the robot 10 from the detection result (a detection value or a measurement value) acquired by the receiver 220 from either the capacitive proximity sensors 110 or the laser sensors 30A and 30B. If the calculated distance is less than a specific distance, the operation controller 240 controls the operation of the robot 10 to stop or decelerate the operation of the robot 10. If the calculated distance is greater than or equal to the specific distance, the operation controller 240 continues the operation of the robot 10. The operation of the operation controller 240 will be described below in further detail with reference to Fig. 4.

### <Processing Procedure>

The functional configuration of the control apparatus 20 has been described above. The processes performed by the object detection system 1 will be described in detail below. Fig. 4 is a flowchart showing exemplary processes performed by the object detection system 1 shown in Fig. 1.

(Step SP10) The object detection system 1 operates the receiver 220 to acquire measurement results of the rotation angles from the respective driving joints of the articulated arm 11 of the robot 10. The object detection system 1 operates the updater 230 to update the position and shape of the robot 10 in the orientation data 212 stored in the storage 210, based on the measurement results of the rotation angles from the respective driving joints of the articulated arm 11 acquired by the receiver 220. The process then proceeds to step SP12.

(Step SP12) The object detection system 1 operates the operation controller 240 to determine whether at least a part of the articulated arm 11 is present within at least one of the detection ranges A1 and A2 of the laser sensors 30A and 30B. Specifically, the object detection system 1 operates the operation controller 212 to reference the detection range data 211 and the orientation data 212 stored in the storage 210. The detector 1 operates the operation controller 240 to determine, using the detection range data 211 and the orientation data 212, whether at least a part of the articulated arm 11 is present in at least one of the detection ranges A1 and A2 of the laser sensors 30A and 30B. If it is determined that at least a part of the articulated arm 11 is present in at least one of the detection rages A1 and A2, the process proceeds to step SP14. On the other hand, if it is determined otherwise, the process proceeds to step SP16.

(Step SP14) The object detection system 1 operates the operation controller 240 to stop or disable the laser sensors 30A and 30B from sensing an interfering object 2. Fig. 5B illustrates the sensing operation of the laser sensors 30A and 30B where at least a part of the articulated arm 11 is present in at least one of the detection ranges A1 and A2. Fig. 5B is a diagram showing an instance where the object detection system 1 shown in Fig. 1 detects an interfering object 2. As shown in Fig. 5B, when at least a part of the articulated arm 11 is present in at least one of the detection ranges A1 and A2 of the laser sensors 30A and 30B, the object detection system 1 only uses the capacitive proximity sensors 110 to sense an interfering object 2. After the laser sensors 30A and 30B are stopped or disabled from sensing an interfering object 2, the object detection system 1 maintains the operation setting related to the detection processing. Returning to Fig. 4, the process proceeds to step SP18.

(Step SP16) The object detection system 1 operates the operation controller 240 to enable the laser sensors 30A and 30B to sense an interfering object 2. Figs. 5A illustrates an operation performed where the articulated arm 11 is outside the detection ranges A1 and A2 of the laser sensors 30A and 30B. Fig. 5A is a diagram showing an instance where the object detection system 1 shown in Fig. 1 detects an interfering object 2. As shown in Fig. 5A, when the articulated arm 11 is outside the detection ranges A1 and A2 of the laser sensors 30A and 30B, the object detection system 1 operates the capacitive proximity sensors 110 and the laser sensors 30A and 30B to sense an interfering object 2. If the laser sensors 30A and 30B are enabled to sense an interfering object 2, the object detection system 1 maintains the operation setting related to the detection processing. Returning to Fig. 4, the process proceeds to step SP18.

(Step SP18) The object detection system 1 operates the receiver 220 to acquire the detection results of any interfering object 2 from the capacitive proximity sensors 110. The object detection system 1 operates the receiver 220 to acquire, from the laser sensors 30A and 30B, the measurement results indicative of the presence or absence of an interfering object 2 and further acquires the distance to the detected interfering object 2. The process then proceeds to step SP20.

(Step SP20) The object detection system 1 operates the operation controller 240 to determine whether the distance between the robot 10 and the detected interfering object 2 is less than a specific distance. Specifically, if any of the detection results from the capacitive proximity sensors 110 indicates the detection of an interfering object 2, the object detection system 1 operates the operation controller 240 to determine that the distance between the detected interfering object 2 and the robot 10 is within the specific distance. Moreover, if the determination results from the laser sensors 30A and 30B indicate that the distance to the detected interfering object 2 is less than the specific distance, the object detection system 1 operates the operation controller 240 to further determine that the distance between the detected interfering object 2 and the robot 10 is within the specific distance. If the determination result from either the capacitive proximity sensors 110 or the laser sensors 30A and 30B indicates that the distance is less than the specific value, the process proceeds to step SP22. On the other hand, if the determination result from neither the capacitive proximity sensors 110 nor the laser sensors 30A and 30B indicates that the measured distance is equal to or greater than the specific distance, the process shown in Fig. 4 ends.

(Step SP22) The object detection system 1 operates the operation controller 240 to stop or decelerate the operation of the articulated arm 11 of the robot 10. The processing shown in Fig. 4 ends.

### <Effects>

As has been described above, in the present embodiment, the object detection system 1 operates the control apparatus 20 to stop or decelerate the operation of the robot 10 in response to the detection results indicating a detection of an interfering object 2 by at least one of the capacitive proximity sensors 110 and the laser sensors 30A and 30B. With the use of the capacitive proximity sensors 110 and the laser sensors 30A and 30B to detect an interfering object 2, the object detection system 1 can thus can detect an interfering object 2 approaching the robot 10 with high accuracy and within a wide range of detection coverage.

In the present embodiment, the control apparatus 20 stops or disables the laser sensors 30A and 30B from sensing an interfering object if a part of the articulated arm 11 is found present in at least one of the detection ranges A1 and A2 set for the laser sensors 30A and 30B to detect an interfering object 2. The object detection system 1 can thus detect an interfering object 2 with higher accuracy, because an erroneous detection by the laser sensors 30A and 30B can be prevented when the articulated arm 11 is present in at least one of the detection ranges A1 and A2 of the laser sensors 30A and 30B.

In the present embodiment, when the articulated arm 11 is found outside the detection ranges A1 and A2 of the laser sensors 30A and 30B, the control apparatus 20 uses both the capacitive proximity sensors 110 and the laser sensors 30A and 30B to sense an interfering object 2. The object detection system 1 can thus detect an interfering object 2 approaching the robot 10 within a wider range of detection coverage.

In the present embodiment, the control apparatus 20 calculates the distance between the detected interfering object 2 and the robot 10, and stops or decelerates the operation of the robot 10 if the calculated distance is within a specific distance. The object detection system 1 can thus prevent collision between the detected interfering object 2 and the robot 10 and can therefore reduce the risk, caused by a collision impact, of mechanical failure of the robot 10 and damage to the interfering objects 2, for example.

### <Modifications>

The object detection system according to the present invention is not limited to the above-described embodiments. Modifications made by those skilled in the art through appropriate design changes to the foregoing embodiments are also included in the scope of the present invention as long as the modifications have the features of the present invention. Moreover, the features described in the foregoing embodiment and modifications described below can be combined where technically feasible. Such combinations are also included in the scope of the present invention as long as the combinations have the features of the present invention.

For example, in the embodiments described above, a pair of laser sensors 30 are disposed on the opposite sides of the base 12 of the robot 10. However, the present invention is not limited thereto. Any number of laser sensors 30 may be disposed at any positions as long as the presence or absence of an interfering object 2 within the specific distance from the robot 10 can be detected. For example, the object detection system 1 may include a plurality of laser sensors 30 that are positioned at different locations near the robot 10 and away from the base 12. Moreover, the object detection system 1 may be configured so that the control apparatus 20 and the plurality of laser sensors 30 can communicate with each other in a wired or wireless manner. With this modification, the laser sensors 30 may be deployed adaptively to the environment where the robot 10 is installed, and the object detection system 1 can therefore detect an interfering object 2 with high accuracy and within a wide area of detection coverage inclusive of locations covered adaptively to the environment around the robot 10.

In the embodiments described above, the object detection system 1 disables or stops the laser sensors 30A and 30B from performing the detection if at least a part of the articulated arm 11 is present in at least one of the detection ranges A1 and A2. However, the present invention is not limited thereto. For example, the object detection system 1 may keep a laser sensor 30 operable, instead of being stopped or disabled, if the laser sensor 30 senses no part of the articulated arm 11 in its detection range A1 or A2. Specifically, where at least a part of the articulated arm 11 is present in the detection range A1, and the articulated arm 11 is positioned in its entirety outside the detection range A2, the object detection system 1 disables or stops the laser sensor 30A from performing the detection and enables or keep operable the detection of the laser sensor 30B. With this modification, the object detection system 1 only disables or stops one of the laser sensors 30A and 30B if said one of the laser sensors 30A and 30B detects at least a part of the articulated arm 11 in its detection range. The object detection system 1 can thus detect an interfering object 2 with even higher accuracy.

In the embodiments described above, the object detection system 1 uses the laser sensors 30 as optical distance sensors. However, the present invention is not limited thereto. For example, instead of the laser sensor 30, the object detection system 1 may use imaging devices such as cameras, alternative to the laser sensors 30, to capture images in imaging areas including the detection ranges A1 and A2. In the modification, the object detection system 1 performs image processing or image analysis on the images captured by the imaging devices to detect the presence or absence of an interfering objects 2 in the imaging areas and measures the distance to the detected interfering objects 2. With the modification, the image processing or image analysis on the captured images enables the object detection system 1 to detect an interfering object 2 with even higher accuracy.

In the embodiments described above, the object detection system 1 stops or decelerates the operation of the robot 10 if the detection results from either the capacitive proximity sensors 110 or the laser sensors 30 indicate the presence of an interfering object in any of the detection ranges. However, the present invention is not limited thereto. The object detection system 1 may operate the operation controller 240 to decelerate the operation of the articulated arm 11 of the robot 10 when the operation controller 240 determines that the detection results from the laser sensors 30A and 30B indicate that the distance between the detected interfering object 2 and the robot 10 is less than a specific distance. Moreover, the object detection system 1 may operate the operation controller 240 to stop the operation of the articulated arm 11 of the robot 10 when the operation controller 240 determines that any of the capacitive proximity sensors 110 detects an interfering object 2. In this modification, the detection ranges A1 and A2 of the laser sensors 30A and 30B may be set greater than the detection ranges of the capacitive proximity sensors 110. With such a modification, the object detection system 1 is operated to decelerate the operation of the robot 10 based on the detection results from the laser sensors 30A and 30B. This modification can free the robot 10 from mechanical stresses caused by hard braking on the operation of the robot 10 that is applied when an interfering object 2 is approaching at high speed.

The object detection system 1 may operate the operation controller 240 to perform different responsive actions depending on the distance, measured by the laser sensors 30A and 30B, between the robot 10 and the detected interfering object 2. Specifically, if the measured distance is greater than or equal to a first distance, the operation controller 240 keeps operable the articulated arm 11 of the robot 10. If the measured distance is greater than or equal to a second distance, which is smaller than the first distance, and less than the first distance, the operation controller 240 decelerates the operation of the articulated arm 11 of the robot 10. If the measured distance is less than the second distance, the operation controller 240 stops the operation of the articulated arm 11 of the robot 10. Moreover, when the capacitive proximity sensors 110 detect an interfering object 2 independently from the laser sensors 30A and 30B, the operation controller 240 stops the operation of the articulated arm 11 of the robot 10. With the modification, the object detection system 1 can decelerate to stop the operation of the robot 10 at different speeds of decelerations according to the measured distances between the robot 10 and the detected interfering object 2. This modification frees the robot from mechanical stresses caused by hard braking on the operation of the robot 10.

The object detection system 1 may operates the receiver 220 to acquire the position of an interfering object 2 detected by the laser sensors 30A and 30B. Moreover, the object detection system 1 may determine whether the distance between the position of the detected interfering object 2 acquired from the laser sensors 30A and 30B and the position of the tool connected to the distal end of the articulated arm 11 is less than a specific distance. If it is determined that the distance is less than the specific distance, the object detection system 1 may decelerate or stop the operation of the robot 10 using the operation controller 240. With the modification, the object detection system 1 can prevent the tool connected to the distal end of the articulated arm 11 of the robot 10 from colliding with an interfering object 2 or reduce the risk, caused by a collision impact, of mechanical failure of the robot 10 and damage to the interfering objects 2, for example. Moreover, when the tool of the robot 10 is positioned at a certain distance or more away from the detected interfering object 2, the object detection system 1 can continue the work without stopping the operation of the robot 10, provided that the operation of the robot is not obstructed by the detected interfering object 2. The object detection system 1 can thus reduce occasions where stopping of the operation of the robot 10 may not be needed and as a result can improve the productivity of the robot 10.

## Claims

1. An object detection system (1) **characterized by** comprising:
a robot (10) including a base (12), an articulated arm (11) connected to the base (12), and a capacitive proximity sensor (110) disposed on the articulated arm (11), wherein the capacitive proximity sensor (110) is operable to detect an interfering object (2);
a pair of laser sensors (30) located at positions opposite with respect to the base (12), wherein the pair of laser sensors (30) are operable to irradiate laser approximately in parallel to an installation surface (S1) of the robot (10) for detection of the interfering object (2) and
a control apparatus (20) programmed to stop or decelerate operation of the robot (10) based on a detection of the interfering object (2) by at least one of the capacitive proximity sensor (110) and the laser sensors (30).

2. The object detection system (1) according to claim 1, **characterized in that** the control apparatus (20) is programmed to stop or disable the laser sensors (30) from performing detection when a part of the articulated arm (11) is detected to be present in a detection range in which the laser sensors (30) can detect an interfering object (2).

3. The object detection system (1) according to claim 2, **characterized in that** the control apparatus (20) is programmed to operate the laser sensors (30) to perform detection of the interfering object (2) when no part of the articulated arm (11) is detected to be present in the detection range of any of the laser sensors (30).

4. The object detection system (1) according to claims 1 to 3, **characterized in that** the control apparatus (20) is programmed to calculate a distance between the interfering object (2) and the robot (10) based on the detection of the interfering object (2) by the capacitive proximity sensor (110) and the laser sensors (30) and to stop or decelerate the operation of the robot (10) in response to the calculated distance less than a specific distance.
